# EUROPÄISCHE PATENTSCHRIFT

(11) **EP 0 697 742 B1**
(45) Veröffentlichungstag und Bekanntmachung des Hinweises auf die Patenterteilung: **31.10.2001**
(21) Anmeldenummer: 95108934.1
(22) Anmeldetag: 09.06.1995
(51) Int. Cl.: H01L 31/0352, H01L 33/00

(54) **Optoelektronisches Quantentopf-Bauelement**
Quantum well optoelectronic device
Dispositif optoélectronique à puits quantiques

(30) Priorität: 17.06.1994 DE 4421201
(43) Veröffentlichungstag der Anmeldung: 21.02.1996
(73) Patentinhaber: DaimlerChrysler AG, 70567 Stuttgart (DE)
(72) Erfinder: Jaros, Milan, Prof., Newcastle-upon-Tyne NE3 1ND (GB); Presting, Hartmut, Dr., D-89075, Ulm (DE); Kibbel, Horst, D-89155, Erbach (DE)
(74) Vertreter: Fröhling, Werner Otto, Dr.

(56) Entgegenhaltungen:
- EP-A- 0 540 235
- US-A- 4 843 439
- SIXTH INTERNATIONAL CONFERENCE ON MODULATED SEMICONDUCTOR STRUCTURES, GARMISCH-PARTENKIRCHEN, GERMANY, 23-27 AUG. 1993, SOLID-STATE ELECTRONICS, APRIL-JUNE 1994, UK, Bd. 37, Nr. 4-6, ISSN 0038-1101, Seiten 1303-1306, SHAW M J ET AL 'GaAs-AlAs and Si-SiGe quantum well structures for applications in nonlinear optics'
- APPLIED PHYSICS LETTERS, 25 OCT. 1993, USA, Bd. 63, Nr. 17, ISSN 0003-6951, Seiten 2378-2380, FUKATSU S ET AL 'Optical investigation of interwell coupling in strained Si/sub 1-x/Ge/sub x//Si quantum wells'

## Beschreibung

Die Erfindung betrifft ein optoelektronisches Bauelement in Silizium-Technologie.

Optoelektronische Bauelemente in Si-Technologie sind von Vorteil durch die monolithische Integrierbarkeit mit integrierten Schaltungen in Si.

Bekannt ist von Schäffler et al. (Journal of Crystal Growth 127, P411,415 (1993)) oder von Fukatsu et al. (Applied Physics Letters 63, p. 2378 (1993)) die Lumineszenz von SiGe-Quantentöpfen. Desweiteren behandelt Shaw, M.J. et al. (Solid State Electronics Vol. 37, No. 4-6, pp. 1303-1306 (1994)) und Fukatsu, S. (Appl. Phys. Lett. 63 (17), pp. 2378-2380) nichtlineare Absorptionsprozesse in einfach verspannten SiGe Quantentöpfen. Das in diesen Schriften beschriebene optoelektronische Bauelement zeigt bereits Quantentopfstrukturen, die aus SiGe/Si Schichten mit ganz geringen Ge-Gehalten gebildet werden.
Die Schrift US 4,843,439 beschreibt ein Bauelement mit einer Übergitterstruktur, bestehend aus SiGe/Si Schichten, in denen der Germaniumgehalt im SiGe zwar variabel ist, jedoch dieser ebenfalls im Bereich geringer Germaniumgehalte liegt.
Auch aus der Schrift EP 0 540 235 ist eine Schichtstruktur mit geringen Ge-Gehalten bis maximal 25% beschrieben. Alle genannten Bauelemente zeigen allerdings eine Lumineszenz im nahen Infrarot erst bei tiefen Temperaturen (T ≤ 30 K).

Aufgabe der vorliegenden Erfindung ist es, ein optoelektronisches Bauelement anzugeben, das bei höheren Temperaturen und insbesondere im nahen Infrarotbereich einsetzbar ist.

Die Erfindung ist im Patentanspruch 1 beschrieben. Die Unteransprüche enthalten vorteilhafte Ausgestaltungen und Weiterbildungen der Erfindung.

Das erfindungsgemäße Bauelement zeigt eine Lumineszenz im nahen Infrarotbereich, die sehr temperaturstabil und auch noch bei Raumtemperatur beobachtbar ist. Eine weitere besonders vorteilhafte Eigenschaft des erfindungsgemäßen Bauelements ist die Möglichkeit, die Wellenlänge der Lumineszenz über die Geometrie der Valenzband-Quantentopfstruktur, insbesondere die Breite der Quantentopf-Schichten und deren Germaniumgehalt, über einen relativ weiten Spektralbereich auf bei der Herstellung einfache Weise variieren zu können. Das erfindungsgemäße Bauelement ist z.B. mittels Molekularstrahlepitaxie einfach herzustellen, insbesondere im Vergleich zu Übergitterstrukturen.

Die den Quantentopf im Valenzband bildende Schicht bzw. die die Quantentöpfe bildenden Schichten bei Wiederholung der Struktur und/oder bei der bevorzugten Doppel-Quantentopfstruktur bestehen vorzugsweise aus Germanium. Für reiner Germanium ist die kritische Schichtdicke im Si-Grundgitter auf einige Monolagen beschränkt. Die Quantentopf-Schichten können daher auch als Si₁₋ₓGeₓ-Schichten mit größerer kritischer Schichtdicke gewachsen werden. Wesentlich ist, daß eine klare Quantentopfstruktur im Valenzband, d.h. ein deutlicher Valenzband-Sprung an den Schichtgrenzen auftritt, vorzugsweise ein Bandsprung von mindestens 0,4 eV. Wesentlich dazu ist die elastische Verspannung und eine niedrige Defektdichte der auf Si-Substrat pseudomorph aufgewachsenen Quantentopfstruktur.

Die Funktion des Bauelements kann erklärt werden durch eine starke Lokalisierung von Löchern in dem Valenzband-Quantentopf der dünnen Ge(bzw. SiGe)-Schicht(en), die durch elektrostatische Anziehung mit Elektronen im Leitungsband die Entstehung eines exzitonischen Band-Band-Übergangs bewirken, und durch eine Streuung von Ladungsträgern an den Grenzflächen der Ge-Schichten zu den Si- bzw. SiGe-Schichten zur Erfüllung der Impulsauswahlregel des im k-Raum indirekten Übergangs. Die Quantentopfschichten sind dazu in geringer Dicke aufzuwachsen, vorzugsweise dünner als 1,5 nm. Für die Erzielung von für die Funktion des erfindungsgemäßen Bauelements vorteilhaften scharfen Schichtgrenzen in der Quantentopf-Struktur ist ein durch Surfactanten (siehe z.B. Copel et al., Physics Review Letters 63, p 632, 1989) unterstütztes Wachstum bei höheren Temperaturen vorteilhaft.

Durch die bevorzugte Ausführung als Doppel-Quantentopf-Struktur in den relevanten Leitungsbandzuständen (Impulsvektor in Wachstumsrichtung) steht der Valenzband-Doppeltopf-Struktur, insbesondere bei (100)-Wachstumsrichtung, eine Leitungsband-Quantentopfstruktur mit Doppelbarriere gegenüber, was zu einer besseren Lokalisierung von Elektronen führt.

Zusätzlich kann durch variierende p-Dotierung über die Lage des Fermi-Energieniveaus die Energie des niedrigsten besetzten Zustands im Valenzband-Quantentopf und damit die Übergangsenergie noch in geringerem Maß verschoben werden.

Die Erfindung ist nachfolgend anhand eines bevorzugten Ausführungsbeispiels unter Bezugnahme auf die Abbildungen noch eingehend veranschaulicht.

Dabei zeigt
- FIG.1: einen Schichtaufbau
- FIG. 2: einen Bandverlauf einer Doppel-Quantentopf-Struktur
- FIG. 3: einen anderen Bandverlauf einer solchen Struktur

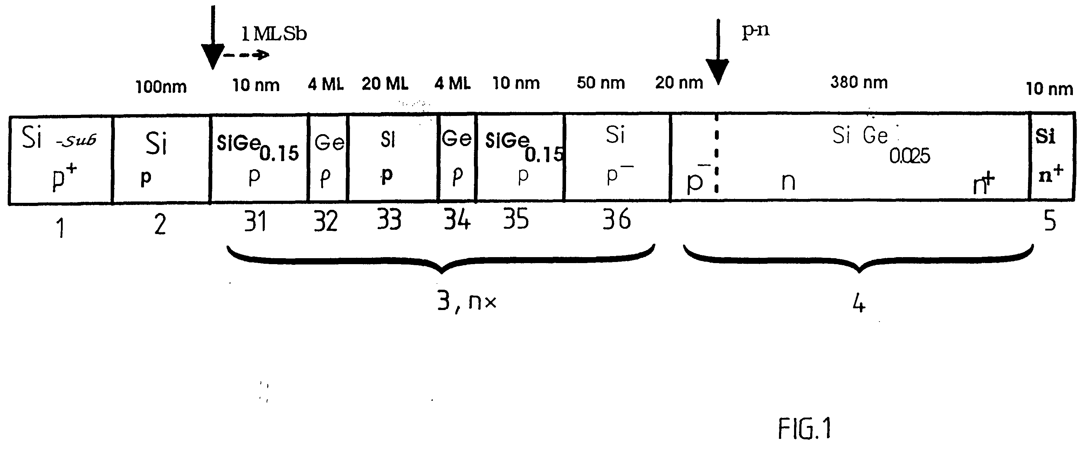

Bei dem in FIG. 1 skizzierten Schichtaufbau ist auf ein p⁺-dotiertes Si-Substrat 1 eine Si-Grundschicht 2 und darauf eine Doppel-Quantentopf-Struktur 3 mit einer ersten Si₁₋ₓGeₓ-Schicht 31, einer dünnen ersten Ge-Schicht 34, einer zweiten Si₁₋ₓGeₓ-Schicht 35 auf gewachsen. Die Doppel-Quantentopf-Struktur 3 ist zur Erzielung höherer Ausbeuten mehrfach (n) wiederholt, wobei aufeinanderfolgende Strukturen durch Si-Zwischenschichten 36 getrennt sind, die eine Stabilisierung des Si-Grundgitters bewirken und ein gleichmäßiges pseudomorphes Wachstum der Doppel-Quantentopf-Strukturen gewährleisten. Der Schichtaufbau schließt in dem skizzierten Beispiel ab mit einem p-n-Übergang in einer SiGe_{0,025}-Schicht 4, die zur Unterstützung der Wellenfühtung für eine seitlich eingekoppelte und in der aktiven Schicht geführte optische Welle vorgesehen ist, und einer dünnen n⁺-dotierten Si-Kontaktschicht 5.

Zur Erzielung scharfer Grenzflächen beim epitaktischen Wachstumsprozeß kann in an sich bekannter Weise auf der Grundschicht 2 eine Atomlage (Monolayer ML) Sb als Surfactant abgeschieden werden. Der Surfactant besetzt aus energetischen Gründen die Oberfläche der Probe durch Platztausch mit dem gerade aufwachsenden Material. Er wandert somit mit dem Aufwachsen der weiteren Halbleiterschichten an der Oberfläche mit und nimmt am eigentlichen Wachstumsprozeß nicht teil. Er unterdrückt aber die sogenannte Segregation (3-dim. Wachstum) der aufwachsenden Schicht und ermöglicht so das präzise Wachstum der nur wenige Monolagen scharfen Heteroschicht-Übergänge. Die Schichten der Doppel-Quantentopf-Struktur sind p-dotiert, vorzugsweise einheitlich mit einer Konzentration von 10¹⁷ cm⁻³ bis 10²⁰cm⁻³, insbesondere 10¹⁸ cm⁻³ bis 10¹⁹cm⁻³, Dotierstoffatomen, z.B. Bor.

Die Dicke der Si₁₋ₓ Geₓ-Schichten 31, 35 ist durch die Forderung nach pseudomorphem Wachstum begrenzt und vom Ge-Gehalt x abhängig und beträgt im skizzierten Beispielsfall 10nm bei x = 0,15. Die Ge-Schichten 32, 34 können auf ein Si-Grundgitter pseudomorph verspannt nur in sehr geringer Dicke aufgewachsen werden und umfassen im Beispielsfall jeweils 4ML. Die Si-Distanzschicht 33 umfaßt maximal 50ML, vorzugsweise weniger als 25 ML und beträgt im skizzierten Beispiel 20ML. Für die Si-Zwischenschichten 36, die eine Hintereinanderschaltung räumlich entkoppelter Quantentopf-Strukturen ermöglichen, ist eine Dicke von z.B. 50 nm vorgesehen.

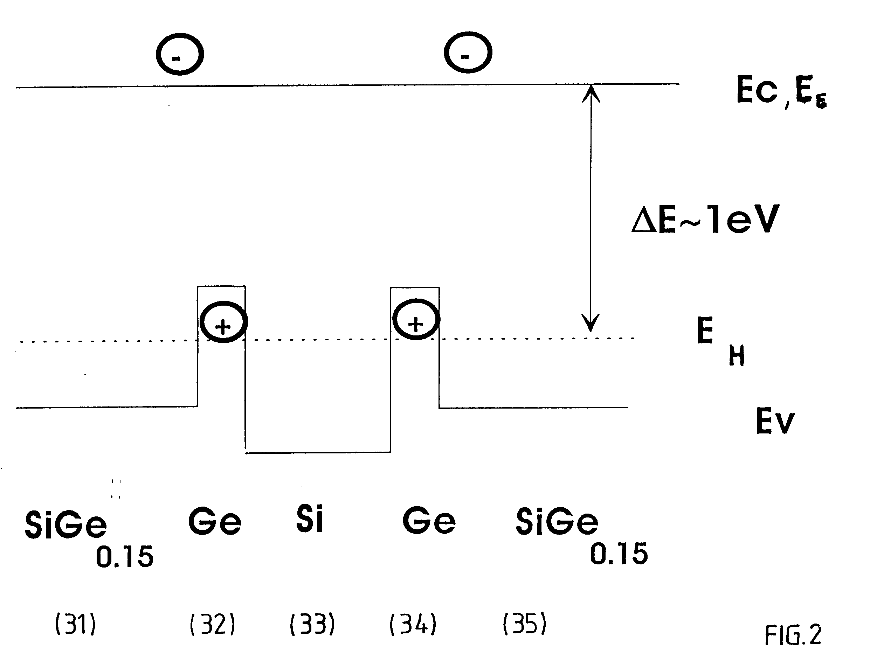

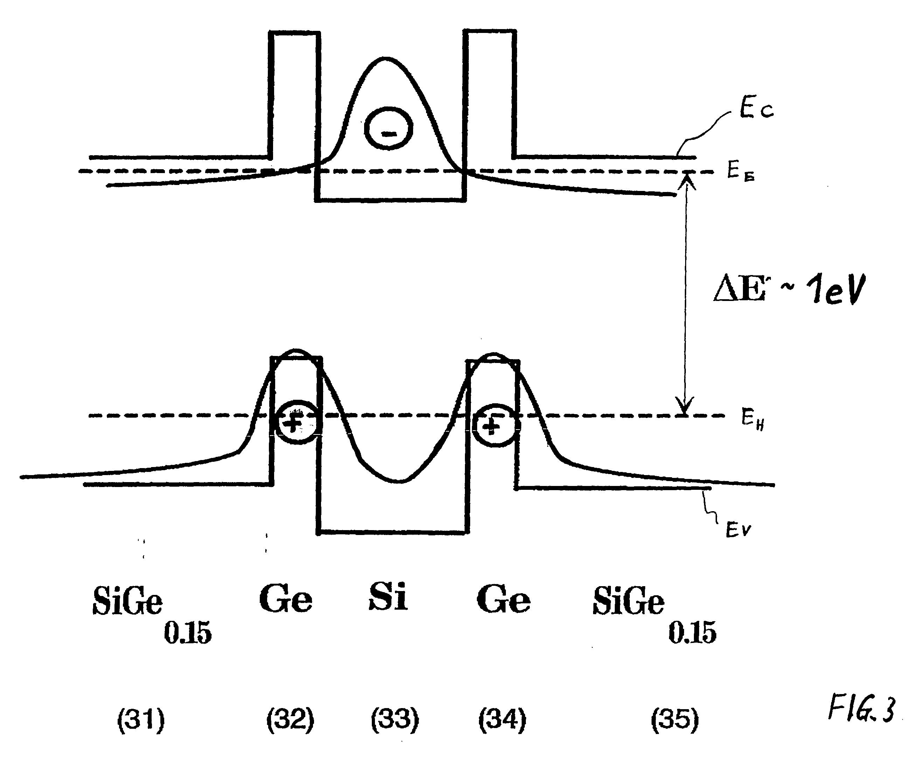

In den durch die verspannten p-dotierten Ge-Schichten 32, 34 gebildeten tiefen Quantentöpfen (FIG. 2, FIG. 3) im Valenzband EV sind die Löcher (+) stark lokalisiert und von den Akzeptorrümpfen getrennt. Dies führt in der räumlichen Nachbarschaft dieser Quantentöpfe zu einer elektrostatischen Anziehung der Löcher mit den in Zuständen des Leitungsbandes Ec befindlichen Elektronen (-) und damit zu einer Absenkung deren Energieniveaus. Daraus resultiert das Auftreten eines exzitonischen Interband-Übergangs, zwischen den jeweils energetisch niedrigsten besetzten Zuständen für Löcher (E_{H}) und Elektronen (E_{E}), dessen Übergangsenergie ΔE für das in FIG. 1 skizzierte Beispiel bei ca. 1 eV liegt.

Das Enerigenieveau E_{H} für in den Quantentöpfen lokalisierte Löcher ist stark abhängig von der Geometrie und der Materialzusammensetzung der Schichten 31 bis 35, insbesondere 32, 33, 34, und kann somit über die Geometrie und Material-Zusammensetzung als Parameter beim Schichtwachstum gesteuert werden. Das Energieniveau E_{E} für Elektronen im Leitungsband variiert nur in weit geringerem Maße mit den vorgenannten Parametern. Der Einfluß des Schichtaufbaus auf die Leitungsbandstruktur ist wegen der richtungsabhängigen, spannungsinduzierten Aufspaltung des entarteten Leitungsbandminimums stark von der Kristallwachstumsrichtung abhängig und kann von einem im wesentlichen unstrukturierten Leitungsbandverlauf für (111)-Wachstumsrichtung wie in FIG. 2 angenommen bis zu einer starken Doppelbarrieren-Struktur wie in FIG. 3 für (100)-Wachstumsrichtung skizziert reichen. Die Doppel-Barrieren-Struktur zeigt wegen der stärkeren Lokalisierung der Elektronenzustände zwischen den den Quantentöpfen im Valenzband entsprechenden Barrieren im Leitungsband eine bessere Temperaturstabilität der Lumineszenz.

Ferner kann die gesamte Struktur statt auf ein Si-Grundgitter unter Einfügen einer Pufferschicht auch auf ein SiGe-Grundgitter als Struktur mit verspannten Si- und Ge-Schichten abgeschieden werden.

Das erfindungsgemäße Bauelement kann sowohl als Lichtquelle als auch als Detektor eingesetzt werden. Die Unterschiede im peripheren Schichtaufbau und den Betriebsparametern sind dem Fachmann geläufig.

## Patentansprüche

1. Optoelektronisches Bauelement in Si-Technologie mit einer p-dotierten Quantentopfstruktur mit mindestens einem Quantentopf in der Valenzbandstruktur, **dadurch gekennzeichnet, daß** der Quantentopf aus zwei, eine Si-Distanzschicht (33) einschließende, pseudomorph verspannten Ge-Schichten (32, 34) zwischen äußeren SiGe-Schichten (31, 35) aufgebaut ist.

2. Bauelement nach Anspruch 1, **dadurch gekennzeichnet, daß** die Dicke der Si-Distanzschicht (33) kleiner als 50 Atomlagen ist, bevorzugt 20 Atomlagen, sowie die maximale Dicke der Ge-Schichten (32, 34) eine durch das pseudomorphe Wachstum begrenzte Anzahl an Atomlagen ist, bevorzugt 4 Atomlagen.

3. Bauelement nach einem der Ansprüche 1 oder 2, **dadurch gekennzeichnet, daß** die Quantentopf-Struktur auf ein Si-Grundgitter aufgewachsen ist.

4. Bauelement nach einem der Ansprüche 1 bis 3, **dadurch gekennzeichnet, daß** die Quantentopf-Struktur auf ein unverspanntes SiGe-Grundgitter aufgewachsen ist.

5. Bauelement nach einem der Ansprüche 1 bis 4, **dadurch gekennzeichnet, daß** mehrere durch unverspannte Grundgitter-Schichten getrennte Quantentopf-Strukturen (3) übereinander angeordnet sind.

6. Verfahren zur Herstellung eines Optoelektronisches Bauelement gemäß eines der Ansprüche 1 bis 5, **dadurch gekennzeichnet, daß** beim Wachstum der pseudomorph verspannten Ge-Schichten (32, 34) zur Ausgestaltung einer exakten Grenzfläche zum Si und/oder SiGe ein Surfactant aus einer Atomlage Antimon (Sb) verwendet wird.

## Claims

1. Optoelectronic component in Si technology having a p-doped quantum-well structure with at least one quantum well in the valence-band structure, **characterized in that** the quantum well is constructed from two pseudomorphously strained Ge layers (32, 34) which enclose an Si spacer layer (33) and are located between outer SiGe layers (31, 35).

2. Component according to Claim 1, **characterized in that** the thickness of the Si spacer layer (33) is less than 50 monolayers, preferably 20 monolayers, and the maximum thickness of the Ge layers (32, 34) is a number of monolayers limited by the pseudomorphous growth, preferably 4 monolayers.

3. Component according to Claim 1 or 2, **characterized in that** the quantum-well structure is grown on an Si base lattice.

4. Component according to one of Claims 1 to 3, **characterized in that** the quantum-well structure is grown on an unstrained SiGe base lattice.

5. Component according to one of Claims 1 to 4, **characterized in that** a plurality of quantum-well structures (3) separated by unstrained base-lattice layers are arranged above one another.

6. Process for producing an optoelectronic component according to one of Claims 1 to 5, **characterized in that** a surfactant comprising one monolayer of antimony (Sb) is used to configure an exact interface with the Si and/or SiGe during the growth of the pseudomorphously strained Ge layers (32, 34).

## Revendications

1. Composant optoélectronique en technologie Si avec une structure à puits quantiques à dopage p comprenant au moins un puits quantique dans la structure de la bande de valence, **caractérisé en ce que** le puits quantique est formé de deux couches de Ge (32, 34) sous tension pseudomorphe, enserrant une couche d'espacement de Si (33), disposées entre des couches de SiGe extérieures (31, 35).

2. Composant selon la revendication 1, **caractérisé en ce que** l'épaisseur de la couche d'espacement de Si (33) est inférieure à 50 couches atomiques, de préférence à 20 couches atomiques, et l'épaisseur maximale des couches de Ge (32, 34) correspond à un nombre de couches atomiques limité par la croissance pseudomorphe, de préférence 4 couches atomiques.

3. Composant selon l'une quelconque des revendications 1 ou 2, **caractérisé en ce que** la structure à puits quantiques est soumise à une croissance sur une grille de base de Si.

4. Composant selon l'une quelconque des revendications 1 à 3, **caractérisé en ce que** la structure à puits quantiques est soumise à une croissance sur une grille de base de SiGe sans tension.

5. Composant selon l'une quelconque des revendications 1 à 4, **caractérisé en ce que** plusieurs structures à puits quantiques (3) séparées par des couches de grille de base sans tension sont agencées l'une sur l'autre.

6. Procédé de fabrication d'un composant optoélectronique selon l'une quelconque des revendications 1 à 5, **caractérisé en ce que**, lors de la croissance des couches de Ge (32, 34) sous tension pseudomorphe afin de former une interface exacte avec le Si et/ou le SiGe, on utilise un agent tensioactif constitué d'une couche atomique d'antimoine (Sb).
